# EUROPÄISCHE PATENTSCHRIFT

(11) **EP 1 029 651 B1**
(45) Veröffentlichungstag und Bekanntmachung des Hinweises auf die Patenterteilung: **23.04.2003**
(21) Anmeldenummer: 00103014.7
(22) Anmeldetag: 15.02.2000
(51) Int. Cl.: B29C 67/00, B29K 105/06, B29B 17/02

(54) **Verfahren zur Herstellung von dreidimensionalen Gegenständen mittels Stereolithographie**
Method to produce three dimensional objects by stereolithography
Procédé de fabrication d'objets tridimensionnels par stéréolithographie

(30) Priorität: 17.02.1999 DE 19906564
(43) Veröffentlichungstag der Anmeldung: 23.08.2000
(73) Patentinhaber: Peschges, Klaus-Jürgen, Prof. Dr.-Ing., 69514 Laudenbach (DE)
(72) Erfinder: Peschges, Klaus-Jürgen, Prof. Dr.-Ing., 69514 Laudenbach (DE)
(74) Vertreter: Dahlmann, Gerhard, Dipl.-Ing.

(56) Entgegenhaltungen:
- EP-A- 0 802 455
- EP-A- 0 810 259
- WO-A-97/23342
- DE-A- 4 408 754
- DE-C- 4 305 201
- FR-A- 2 703 945
- JP-A- 8 099 360
- JP-A- 8 332 673
- US-A- 5 304 329
- US-A- 5 591 563
- US-A- 5 683 040

## Beschreibung

### Technisches Gebiet

Die Erfindung betrifft ein Verfahren zur Herstellung von dreidimensionalen Gegenständen mittels Stereolithographie.

Ein Verfahren vergleichbarer Art ist z.B. aus der DE-C-4 305 201 bekannt.

In den letzten Jahren hat eine Technik starke Verbreitung gefunden, bei der dreidimensionale Gegenstände zunächst mit Hilfe von CAD-Software konstruiert werden, die sodann über Stereolithographie zu Gegenständen umgesetzt werden. Über Laserlicht werden vorbestimmte Bereiche einer ständig neu nachfolgenden Schicht eines Harzbades ausgehärtet.

### Stand der Technik

Die Stereolithographie ist bisher auf die Erstellung von Anschauungs- und Designmodellen beschränkt. Das Aushärten erfolgt über einen Ultraviolett-Laser der schichtweise ein Becken mit flüssigem Harz überstreicht und an den vorbestimmten Stellen aushärtet. Die hergestellten Gegenstände werden als Anschauungsmodelle benutzt, um beispielsweise ihre Einbaufreundlichkeit mit Nachbarteilen zu überprüfen. Die Gegenstände haben eine vergleichsweise geringe Härte und ihr Einsatzbereich ist auf den angegebenen Zweck beschränkt.

Durch die DE 43 05 201 C1 ist die Verwendung von Keramik-oder Metallpulver als Füllmaterial bei polymerisierbarem Kunststoff für die Stereolithographie bekannt geworden. Dabei wird ein Körper aus Kunststoff und Füllmaterial hergestellt, aus dem, um zum fertigen Gegenstand zu kommen, der Kunststoff wieder entfernt wird. Der fertige Gegenstand besteht letztlich aus dem eingesetzten Füllmaterial und ist relativ zerbrechlich. Erst durch eine anschließende Sinterung erhölt er eine gewünschte Festigkeit und Oberflächengüte.

Die EP 0 810 259 A1 befaßt sich mit der Beigabe von nanodispersen Füllstoffen zu Polyamidformmassen für die Herstellung von Polyamidschichten.

In der DE 44 08 754 A1 ist der Vorschlag enthalten, bei der Stereolithographie mittels Hochfrequenz oder Ultraschall zu einer gleichmäßig dicken Schicht zu gelangen.

Die FR-A-2 703 945 befaßt sich mit selektiven Aushärtungsmechanismen bei der Stereolithographie.

Die EP 0 802 455 A1 beschreibt eine Harzmischung für die Stereolithographie zur Erhöhung der thermischen Erweichungstemperatur der Harze.

Schließlich beschreibt die US-A-5,305,329 ein selektives Laser-Sinter-Verfahren zur Rückgewinnung von Pulver eines thermisch zersetzbaren Materials, bei dem das Pulver während der Rückgewinnung gekühlt wird.

Der vorliegenden Erfindung liegt ausgehend von der DE 43 05 201 C1 die Aufgabe zugrunde, das eingangs genannte Verfahren so zu verbessern, daß die Herstellung auch von Gegenständen mit bisher nicht erreichten Eigenschaften möglich ist, z.B. von Gegenständen mit erhöhter Festigkeit, erhälter Wärmeleitfähigkeit, besonders ausgebildeten Oberflächen und dergleichen mehr.

Die Lösung der gestellten Aufgabe wird bei einem Verfahren zur Herstellung von dreidimensionalen Gegenständen mittels Stereolithographie, bei dem ein Laserstrahl vorbestimmte Bereiche einer ständig nachfolgenden Schicht eines Harzbad-Partikel-Gemisches aushärtet, wobei im Harzbad-Partikel-Gemisch die physikalischen und/oder mechanischen Eigenschaften des herzustellenden Gegenstandes bestimmende Partikel enthalten sind und die Laserbestrahlung eine Einbindung der Partikel in das ausgehärtete Harz bewirkt, erfindungsgemäß dadurch erreicht, daß die Partikel vor ihrer Beigabe in das Harzbad oberflächenaktiviert wurden und die Laserbestrahlung eine Verbindung der Partikel mit dem Harz und/oder untereinander bewirkt.

Zweckmäßige Weiterbildungen der Erfindung sind Gegenstand der abhängigen Ansprüche.

Die Ausbildung der Partikel und ihre Zugabeart läßt sich in weiten Bereichen variieren. So ist es grundsätzlich möglich die Partikel in fester und/oder flüssiger und/oder gasförmiger Form dem Harzbad zuzugeben und darin zu verteilen. Dabei lassen sich die Partikel selbst auch nahezu beliebig modifizieren. So sind beispielsweise flüssige oder feste Partikel einsetzbar, die auf ihrer Oberfläche oder auch in ihrem Inneren mit Gasbläschen versehen sind. Dadurch können beispielsweise isolierende Eigenschaften erreicht werden. Dem gleichen Einsatzzweck dient auch die Verwendung von Partikeln, die unter Lasereinstrahlung in Gasform übergehen, wodurch Hohlräume in dem hergestellten Gegenstand erreicht werden. Sinnvoll ist auch die Einbringung von Partikeln aus Nanowerkstoff, z.B. in Form von Nanometall oder Nanofluiden, wenn besondere aus dem Metall resultierende Eigenschaften erreicht werden sollen, z.B. eine hohe Leitfähigkeit (elektrische, magnetische oder Wärme-).

Eine hohe Wärmeleitfähigkeit kann beispielsweise auch erreicht werden, wenn vorzugsweise flüssige Harzpartikel eingebracht werden, die ausgehärtet eine hohe Leitfähigkeit zur Folge haben. Beim Einbringen können die flüssigen Harzpartikel mit einer Trennschicht überzogen sein, die ihre Löslichkeit im Harzbad selbst unterbindet.

Gute Ergebnisse können auch erreicht werden, wenn die einzubringenden Partikel mit einer ihre Verbindung zum Harz und/oder untereinander aktivierenden Schicht, vorzugsweise mit einem Fluid überzogen wurden. So ist es möglich, die Partikel mit laser-sinterfähigem Material zu umhüllen und einem Harzbad in hoher Konzentration oder agglomerierend beizugeben.

Für den Fall daß eine möglichst gleichmäßige Verteilung der Partikel im Harzbad erreicht werden soll, kann das Harzbad-Partikel-Gemisch mit Ultraschall beaufschlagt werden. Dieses führt zu der gewollten gleichmäßigen Verteilung oder erhält diesen Zustand.

Die Oberflächen Aktivierung kann auf unterschiedliche Weise erfolgen. So können die Partikel aus einem Kunststoff einer Plasmaaktivierung unterzogen werden. Partikel aus Metall oder einer Metallverbindung werden in der Regel einer chemischen Aktivierung unterzogen. Die Aktivierung läßt sich ebenso durch spezifische Nanomaterialien, bevorzugt in Fluidform erreichen.

Bei vielen Gegenständen ist es von Vorteil, daß bestimmte Teile des Gegenstands besondere Eigenschaften aufweisen, z.B. wenn von der Oberfläche des Gegenstands eine hohe Wärmeleitfähigkeit oder die Verschmutzung hemmende Eigenschaften verlangt werden. Für solche Fälle können die Partikel selektiv beigegeben werden, um eine höhere Anreicherung der Partikel in dem betreffenden Teil der Gegenstände zu erreichen. Diese selektive Beigabe der Partikel wird analog zur Tintenstrahltechnik oder Siebdrucktechnik bewirkt. Möglich ist auch die Partikel aus Metall im nicht ausgehärteten Zustand des Harzbad-Partikel-Gemisches einer elektromagnetischen Ausrichtung zu unterwerfen.

In ausgewählten Fällen kann es von Vorteil sein, wenn das Harzbad einer unmittelbar aufeinanderfolgenden zweimaligen Laserbestrahlung unterworfen wird, wobei die erste Bestrahlung mit reduzierter Energie durchgeführt wird. Dieses ist beispielsweise angebracht, wenn in das Harzbad die Partikel gasförmig eingebracht wurden. Hier kann zunächst mit einem energiereduzierten Initial-Laserstrahl eine Temperaturerhöhung des Gemisches erreicht werden und die Gasbläschen vergrößert werden. Die unmittelbar danach durchgeführte normale Laserbestrahlung ergibt die endgültige Aushärtung. Es ist aber auch möglich die Gaspartikel im Harzbad zu lösen und durch den Initial-Laserstrahl zumindest teilweise in Gasblasen zu überführen. Durch die Intensität und Zeitdauer der Laserbestrahlung kann die Größe der Gasblasen bestimmt werden.

Ein besonderer Vorteil der nach obigem Verfahren hergestellten Gegenstände ist darin zu sehen, daß sie recycelbar sind. Sie können in ihre Ursprungsmaterialien wieder zerlegt werden. Hierfür kann eine Recyclingbehandlung angewendet werden, bei der zunächst ein Zermahlen des Gegenstandes unter Verwendung von flüssigem Stickstoff und ein anschließendes Sichten des Harzes und der Partikel stattfindet.

### Beispiele:

Die Herstellung eines fertigen Produktes z.B. eines künstlerisch gestalteten Briefbeschwerers kann wie folgt durchgeführt werden. Es wird ein Bad aus einem Harz hergestellt, dem Partikel aus Titanpulver beigegeben werden. Es wird ein Harzbad-Titanpartikel-Gemisch gebildet. Aus diesem Gemisch wird mittels Stereolithographie der Briefbeschwerer hergestellt. Die Titanpartikel sind in das ausgehärtete Harz eingebunden und der Briefbeschwerer ist bezüglich Aussehen, Glanz, Gewicht u.s.w. vergleichbar mit einem aus reinem Titan hergestellten Briefbeschwerer. In der gleichen Vorgehensweise können andere Gegenstände mit den gewünschten Eigenschaften durch Beigabe anderer. Partikel hergestellt werden. Die zum Stand der Technik zählenden Stereolithographie-Verfahren waren zur Herstellung solcher Produkte nicht geeignet.

Mit dem neuen Verfahren ist es auch möglich, Werkzeugeinsätze unmittelbar herzustellen, ohne den Zwischenschritt über eine Gußform. Um einen solchen Werkzeugeinsatz herzustellen, wird zunächst ein Bad aus einem Harz gebildet. In dieses Bad werden Partikel eingebracht, die ausgehärtet dem Werkzeugeinsatz eine hohe Druckfestigkeit erteilen. Die Partikel können beispielsweise aus einem Metall gebildet sein und als Metallpulver vorliegen.
Es wird ein Harzbad-Metallpartikel-Gemisch erzeugt und daraus im Stereolithographieverfahren ein Basiskörper gebildet. Die Außenform des Basiskörpers ist so, daß er in einen entsprechenden Werkzeugrahmen eingesetzt oder mit einer Armierung versehen werden kann. In den Basiskörper können über Stereolithographie die Kanäle eingefügt werden, um den in der späteren Produktion entstehenden Wärmeüberschuß abzuführen oder auch ggf. erforderliche Wärme zuzuführen. Die Innenflächen des Werkzeugeinsatzes, welche die Begrenzung für das gefertigte Spritzgießprodukt darstellen, können mit zusätzlich zugegebenen Partikeln versehen werden, um dadurch eine besondere Oberflächengüte zu erreichen.

So können beispielsweise um eine geringe Verschmutzungsneigung zu haben PTFE-Pulver oder ein Nanofluid mit fluorisierten Seitengruppen zugeführt werden. Dieses Pulver oder Nanomaterial wird in das Harz eingebunden und ergibt die gewollte Oberfläche. Desweiteren kann an besonderen Stellen des Werkzeugeinsatzes die Verschleißneigung reduziert werden, z. B. an den Kanten des Werkzeugeinsatzes, indem ein Metallpulverharz dieser Stelle zugeführt wird. Der so hergestellte Werkzeugeinsatz kann direkt für eine Serienproduktion eines Gegenstandes benutzt werden.

## Patentansprüche

1. Verfahren zur Herstellung von dreidimensionalen Gegenständen mittels Stereolithographie, bei dem ein Laserstrahl vorbestimmte Bereiche einer ständig neu nachfolgenden Schicht eines Harzbad-Partikel-Gemisches aushärtet, wobei im Harzbad-Partikel-Gemisch die physikalischen Eigenschaften des herzustellenden Gegenstandes bestimmende Partikel enthalten sind und die Laserbestrahlung eine Einbindung der Partikel in das ausgehärtete Harz bewirkt, **dadurch gekennzeichnet, daß** die Partikel vor ihrer Beigabe in das Harzbad oberflächenaktiviert wurden und die Laserbestrahlung eine Verbindung der Partikel mit dem Harz und/oder untereinander bewirkt.

2. Verfahren nach Anspruch 1, **dadurch gekennzeichnet, daß** die Partikel während der Laserbestrahlung dem Harzbad beigegeben werden.

3. Verfahren nach Anspruch 1 oder 2, **dadurch gekennzeichnet, daß** die Partikel in fester und/oder flüssiger und/oder gasförmiger Form dem Harzbad beigegeben und darin verteilt werden.

4. Verfahren nach einem der Ansprüche 1 bis 3, **dadurch gekennzeichnet, daß** die Partikel in flüssiger oder fester Form auf ihrer Oberfläche oder in ihrem Inneren mit Gasbläschen versehen sind.

5. Verfahren nach Anspruch 1, **dadurch gekennzeichnet, daß** die Partikel unter Laserstrahl-Einwirkung in die Gasform übergehen.

6. Verfahren nach einem der Ansprüche 1 bis 3, **dadurch gekennzeichnet, daß** die Partikel aus Nanowerkstoff in Form von Nanometall oder Nanofluiden eingebracht werden.

7. Verfahren nach einem der Ansprüche 1 bis 6, **dadurch gekennzeichnet, daß** die Partikel mit einem ihre Verbindung zum Harz und/oder untereinander aktivierenden Schicht vorzugsweise einem Fluid überzogen wurden.

8. Verfahren nach einem der Ansprüche 1 bis 6, **dadurch gekennzeichnet, daß** die Partikel mit einem laser-sinterfähigen Material umhüllt in hoher Konzentration oder agglomerierend dem Harzbad beigegeben werden.

9. Verfahren nach einem der Ansprüche 1 bis 8, **dadurch gekennzeichnet, daß** zur gleichmäßigen Verteilung der Partikel im Harzbad, das Harzbad-Partikel-Gemisch mit Ultraschall beaufschlagt wird.

10. Verfahren nach einem der Ansprüche 1 bis 6, **dadurch gekennzeichnet, daß** aus einem Kunststoff bestehende Partikel einer Plasmaaktivierung unterzogen wurden.

11. Verfahren nach einem der Ansprüche 1 bis 6, **dadurch gekennzeichnet, daß** aus einem Metall oder einer Metallverbindung bestehende Partikel einer chemischen Aktivierung unterzogen wurden.

12. Verfahren nach einem der Ansprüche 1 bis 6, **dadurch gekennzeichnet, daß** die Partikel durch Nanomaterialien, insbesondere in Fluidform aktiviert wurden.

13. Verfahren nach einem der Ansprüche 1 bis 12, **dadurch gekennzeichnet, daß** die Partikel selektiv beigegeben werden.

14. Verfahren nach Anspruch 13, **dadurch gekennzeichnet, daß** die selektive Beigabe der Partikel analog zur Tintenstrahltechnik und/oder Siebdrucktechnik erfolgt.

15. Verfahren nach einem der Ansprüche 1 bis 12, **dadurch gekennzeichnet, daß** Partikel mit magnetischen Eigenschaften, insbesondere aus Metall im unausgehärteten Zustand des Harzbad-Partikel-Gemisches einer elektromagnetischen Ausrichtung unterworfen werden.

16. Verfahren nach einem der Ansprüche 1 bis 15, **dadurch gekennzeichnet, daß** das Harzbad-Partikel-Gemisch einer unmittelbar aufeinanderfolgenden zweimaligen Laserbestrahlung unterworfen wird, wobei die erste Bestrahlung mit reduzierter Energie durchgeführt wird.

17. Gegenstand hergestellt nach dem Verfahren der Ansprüche 1 bis 16, **dadurch gekennzeichnet, daß** der Gegenstand recycelbar ist, wobei die Recyclingbehandlung durch Zermahlen des Gegenstandes unter Verwendung von flüssigem Stickstoff und anschließendem Sichten des Harzes und der Partikel erfolgt.

## Claims

1. Method to produce three-dimensional objects by stereolithography, in which particular areas of a permanently renewed layer of a resin-fluid-particle mixture is hardened by a laser ray, and in which the resin-fluid-particle mixture contains the physical and/or mechanical characteristics of the object-to-be-produced, and the laser exposure effectuating a compounding of the particles in the hardened resin, **characterized by** the fact that the particles' surface has been activated before they are added to the resin liquid and the laser exposure causes a compounding of the particles with the resin and/or with the particles themselves.

2. Method according to claim 1, **characterized by** the fact that the particles are being added to the resin liquid during laser exposure.

3. Method according to claim 1 or 2, **characterized by** the fact that the particles in solid and/or liquid and/or gaseous state are added to the resin liquid and are being distributed within.

4. Method according to one of the claims 1 to 3, **characterized by** the fact that the particles in liquid or solid state have gas bubbles inside or on their surface.

5. Method according to claim 1, **characterized by** the fact that the particles become gaseous under laser exposure.

6. Method according to one of the claims 1 to 3, **characterized by** the fact that the particles made of nano material are added in the form of nano metal or nano fluids.

7. Method according to one of the claims 1 to 6, **characterized by** the fact that the particles are being covered with a - preferably fluid - layer which activates their compounding with the resin or their compounding with themselves.

8. Method according to one of the claims 1 to 6, **characterized by** the fact that the particles, covered by a material allowing laser-sintering, are added to the resin fluid in high concentrations or in agglomerated state.

9. Method according to one of the claims 1 to 8, **characterized by** the fact that the resin-fluid-particle mixture is treated with ultrasonic in order to evenly distribute the particles in it.

10. Method according to one of the claims 1 to 6, **characterized by** the fact that particles consisting of a synthetic material are plasma-activated.

11. Method according to one of the claims 1 to 6, **characterized by** the fact that particles consisting of a metal or a metal compound are chemically activated.

12. Method according to one of the claims 1 to 6, **characterized by** the fact that the particles were activated by nano material, particularly in fluid condition.

13. Method according to one of the claims 1 to 12, **characterized by** the fact that the particles are added selectively.

14. Method according to claim 13, **characterized by** the fact that the particles are selectively added analogous to the ink jet and/or silk screen printing techniques.

15. Method according to one of the claims 1 to 12, **characterized by** the fact that particles with magnetic characteristics, particularly consisting of metal, are aligned electromagnetically before the hardening of the resin fluid-particle mixture.

16. Method according to one of the claims 1 to 15, **characterized by** the fact that the resin fluid-particle mixture is being exposed to laser light twice, the first exposure is executed with reduced energy.

17. The object produced according to the method of the claims 1 to 17, **characterized by** the fact that the object is recyclable; the recycling of which is carried out by the grinding of the object using liquid nitrogen with subsequent sorting of the resin from the particles.

## Revendications

1. Procédé de fabrication d'objets tridimensionnels par stéréolithographie où un rayon de laser durcit des parties préalablement définies d'une couche constamment renouvelée d'un bain de résine-particules où se trouvent des particules possédant les propriétés physiques et/ou mécaniques de l'objet à fabriquer et où, par l'intermédiaire d'un laser, les particules sont liées à la résine durcie ou entre elles-mêmes, tout en activant les particules avant de les ajouter au bain de résine durcie.

2. Procédé d'après le droit 1, marqué par le fait que les particules sont ajoutées au bain de résine lors du traitement laser.

3. Procédé d'après les droits 1 ou 2, marqué par le fait que les particules sont ajoutées au bain de résine sous forme solide et/ou liquide et/ou gazeuse et y sont distribuées.

4. Procédé d'après un des droits 1 à 3, marqué par le fait que les particules solides ou liquides ont des bulles de gaz sur leur surface ou dans l'intérieur.

5. Procédé d'après le droit 1, marqué par le fait que les particules deviennent gazeuses par le traitement laser.

6. Procédé d'après un des droits 1 à 3, marqué par le fait que les particules en nano-matériau sont ajoutées en tant que nano-métal ou nano-fluides.

7. Procédé d'après un des droits 1 à 6, marqué par le fait que les particules sont couverts par une couche, de préférence fluide, qui active leur liaison avec la résine ou entre elles-mêmes.

8. Procédé d'après un des droits 1 à 6, marqué par le fait que les particules, enveloppées avec un matériau apte d'être traité par laser ou par sintérisation, sont ajoutées en haute concentration ou en état aggloméré .

9. Procédé d'après un des droits 1 à 8, marqué par le fait que le mélange de bain de résine-particules est traité avec ultrason de sorte que les particules soient régulièrement distribuées dans le bain de résine.

10. Procédé d'après un des droits 1 à 6, marqué par le fait que les particules en matière plastique ont été traitées par une activation du plasma.

11. Procédé d'après un des droits 1 à 6, marqué par le fait que les particules en métal ou en une liaison métallique ont été traitées de façon chimique.

12. Procédé d'après un des droits 1 à 6, marqué par le fait que les particules en nano-matériau, particulièrement sous la forme fluide, ont été activées.

13. Procédé d'après un des droits 1 à 12, marqué par le fait que les particules sont ajoutées sélectivement.

14. Procédé d'après le droit 13, marqué par le fait que l'adduction des particules est analogue à la technique de jet d'encre ou à la sérigraphie.

15. Procédé d'après un des droits 1 à 12, marqué par le fait que des particules possédant des propriétés magnétiques, particulièrement en métal, sont alignées de façon électromagnétique dans un bain de résine non-durci.

16. Procédé d'après un des droits 1 à 15, marqué par le fait que le mélange de bain de résine-particules est traité deux fois de suite avec un laser, où le premier traitement est effectué avec de l'énergie réduite.

17. L'objet sera fabriqué d'après le procédé des droits 1 à 17, marqué par le fait que l'objet est recyclable, en appliquant un traitement de recyclage où l'objet sera moulu en utilisant de l'azote liquide avec examen de la résine et des particules ensuite.
